# EUROPEAN PATENT APPLICATION

(11) **EP 2 720 371 A1**
(43) Date of publication of application: **16.04.2014**
(21) Application number: 13275219.7
(22) Date of filing: 16.09.2013
(51) Int. Cl.: H03B 5/32

(54) **Crystal oscillator**

(30) Priority: 12.10.2012 KR 20120113707
(71) Applicant: Samsung Electro-Mechanics Co., Ltd, Suwon, Gyunggi-Do (KR)
(72) Inventor: Lim, Joon Hyung, Gyunggi-do (KR); Cho, Koon Shik, Gyunggi-do (KR); Kim, Myeung Su, Gyunggi-do (KR)
(74) Representative: Powell, Timothy John

(57) **Abstract**

There is provided a crystal oscillator including an oscillating unit outputting an oscillating signal; a driving unit driving the oscillating unit, a waveform converting unit shaping a waveform of the oscillating signal, a current supplying unit applying an operating signal to the driving unit and the waveform converting unit, and a controlling unit applying a control signal to at least one of the oscillating unit and the current supplying unit based on an output of the waveform converting unit.

## Description

### CROSS-REFERENCE TO RELATED APPLICATION

This application claims the benefit of Korean Patent Application No. 10-2012-0113707 filed on October 12, 2012, with the Korean Intellectual Property Office, the disclosure of which is incorporated herein by reference.

### BACKGROUND OF THE INVENTION

### Field of the Invention

The present invention relates to a crystal oscillator.

### Description of the Related Art

In general, a crystal oscillator is an apparatus generating an oscillating frequency having high stability by using a crystal vibrator using piezoelectric properties of a quartz crystal, as a control element of the oscillating frequency.

The above-mentioned crystal oscillator is used in an oscillating circuit of a computer and a communications device since it may obtain a stabilized frequency.

Meanwhile, products such as a voltage-controlled crystal oscillator (VCXO), a temperature compensated crystal oscillator (TCXO), an oven controlled crystal oscillator (OCXO), and the like further improving the crystal oscillator may more finely control a frequency, such that they are often used as key device components providing a reference for all signals.

Recently, in accordance with the development of technology, the use of portable electronic devices has rapidly grown. In a case of the above-mentioned portable electronic devices, low power consumption has been emphasized in order to extend battery life.

In accordance with this demand, a demand for an oscillating circuit consuming a low amount of power has increased.

The Related Art Document relates to an invention for a low power crystal oscillator, but does not disclose a configuration for driving a crystal oscillator based on a result of an oscillated output.

### [Related Art Document]

Korean Patent Laid-Open Publication No. 1992-0022680

### SUMMARY OF THE INVENTION

An aspect of the present invention provides a crystal oscillator capable of significantly increasing battery life.

In addition, another aspect of the present invention provides a crystal oscillator capable of securing oscillating stability.

In addition, another aspect of the present invention provides a crystal oscillator capable of guaranteeing a degree of precision in a frequency.

According to an aspect of the present invention, there is provided a crystal oscillator, including: an oscillating unit outputting an oscillating signal; a driving unit driving the oscillating unit; a waveform converting unit shaping a waveform of the oscillating signal; a current supplying unit applying an operating signal to the driving unit and the waveform converting unit; and a controlling unit applying a control signal to at least one of the oscillating unit and the current supplying unit based on an output of the waveform converting unit.

The oscillating unit may include a crystal vibrator, a load capacitor, and a feedback resistor.

The oscillating unit may include a variable capacitor adjusting an oscillating frequency based on the control signal.

The waveform converting unit may include a plurality of inverters.

The current supplying unit may include a reference current generating unit and a current mirroring unit.

The current supplying unit may include a variable resistor adjusting a reference current based on the control signal.

According to an aspect of the present invention, there is provided a crystal oscillator, including: a waveform converting unit shaping and outputting an oscillating signal; a controlling unit generating a control signal based on an output of the waveform converting unit; and a current supplying unit outputting an operating signal based on the control signal of the controlling unit.

The crystal oscillator may further include an oscillating unit outputting a predetermined oscillating signal based on the control signal of the controlling unit.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a block diagram of a crystal oscillator according to an embodiment of the present invention;
FIG. 2 is a view illustrating an example of a variable capacitor; and
FIG. 3 is a view illustrating an example of a variable resistor.

### DETAILED DESCRIPTION OF THE EMBODIMENTS

Hereinafter, embodiments of the present invention will be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and dimensions of elements may be exaggerated for clarity, and the same reference numerals will be used throughout to designate the same or like elements.

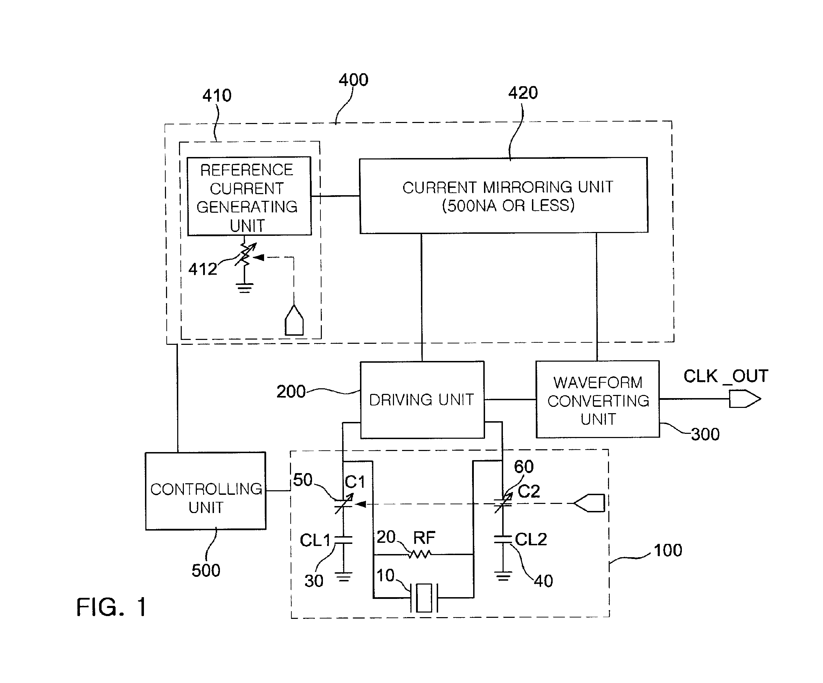

FIG. 1 is a block diagram of a crystal oscillator according to an embodiment of the present invention.

Referring to FIG. 1, the crystal oscillator may include an oscillating unit 100, a driving unit 200, a waveform converting unit 300, a current supplying unit 400, and a controlling unit 500.

The oscillating unit 100 may output an oscillating signal. For example, the oscillating unit 100 includes a piezoelectric vibrator 10, wherein the piezoelectric vibrator 10 may output the oscillating signal vibrating at a natural frequency (for example, 32.768KHz). Here, since the piezoelectric vibrator 10 needs to have a precise frequency, a quartz vibrator is generally used therefor.

In addition, the oscillating unit 100 may include a feedback resistor 20, load capacitors 30 and 40, variable capacitors 50 and 60.

According to an embodiment of the present invention, both terminals of the piezoelectric vibrator 10 and both terminals of the feedback resistor 20 may be connected to each other.

The feedback resistor 20 may feedback a signal to the driving unit 200 and may prevent an over-current from being applied to the piezoelectric vibrator 10. In addition, the feedback resistor 20 may block a frequency other than a basic frequency from being generated by the piezoelectric vibrator 10.

According to an embodiment of the present invention, one capacitor 50 and one load capacitor 30 may be disposed between one terminal of the piezoelectric vibrator 10 and a ground.

In addition, one variable capacitor 60 and one load capacitor 40 may be disposed between the other terminal of the piezoelectric vibrator 10 and the ground.

The variable capacitors 50 and 60 have a configuration for improving a degree of precision of a frequency of the crystal oscillator. A specific configuration thereof will be provided below.

The driving unit 200 may drive the oscillating unit 100. The driving unit 200 may amplify the oscillating signal generated by the oscillating unit 100 to a predetermined level.

Meanwhile, the driving unit 200 may be operated based on an operating signal applied by the current supplying unit 400. For example, the driving unit 200 may adjust a negative-resistance based on a current value applied by the current supplying unit.

The current applied to the driving unit 200 may have a value for stably performing an oscillating operation. Meanwhile, the current may have a minimum value in the above-mentioned condition.

The reason is that as the current has a smaller value in the condition as described above, power consumption of the crystal oscillator may be decreased.

The waveform converting unit 300 may perform waveform shaping of the oscillating signal amplified by the driving unit 200 to output an oscillating output signal CLK_OUT. For example, the oscillating output signal CLK_OUT may be a square wave.

The waveform converting unit 300 may include a plurality of inverters.

Meanwhile, the waveform converting unit 300 may be operated based on the operating signal applied by the current supplying unit 400. For example, the operating signal may be a current value output from the current supplying unit 400.

The current applied to the waveform converting unit 300 may have a value for stably performing the waveform shaping. Meanwhile, the current may have a minimum value in the above-mentioned condition.

The reason is that as the current has a smaller value in the condition as described above, power consumption of the crystal oscillator may be decreased.

The current supplying unit 400 may generate an operating signal for driving the driving unit 200 and the waveform converting unit 300.

The current supplying unit 400 may include a reference current generating unit 410 and a current mirroring unit 420.

The reference current generating unit 410 may generate a predetermined current.

Meanwhile, the reference current generating unit 410 may include a variable resistor 412 for adjusting a reference current.

A specific configuration of the variable resistor will be provided in detail below.

The reference current generating unit 410 may generate the reference current to have a level of 100nA or less.

The current mirroring unit 420 may output a plurality of currents based on the current generated by the reference current generating unit 410. For example, the current mirroring unit 420 may output a current generated by amplifying or reducing the current value generated by the reference current generating unit 410.

The current output from the current mirroring unit 420 may operate the driving unit 200 and the waveform converting unit 300.

Therefore, the current output from the current mirroring unit may be collectively known as an operating signal.

The current mirroring unit 420 may generate the operating signal of 500nA or less.

The controlling unit 500 may apply a control signal to the oscillating unit 100 and the current supplying unit 400 based on the output CLK_OUT of the waveform converting unit.

Here, the control signal applied to the oscillating unit 100 by the controlling unit 500 is defined as a first control signal.

In addition, the control signal applied to the current supplying unit 400 by the controlling unit 500 is defined as a second control signal.

The first control signal may adjust capacitance values of the variable capacitors 50 and 60.

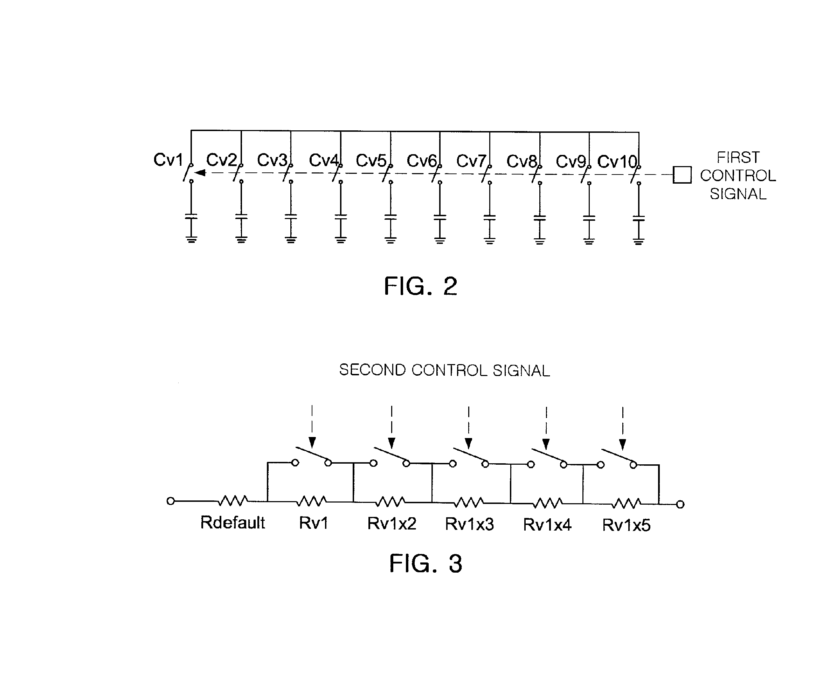

FIG. 2 is a view illustrating an example of a variable capacitor 50. For example, the variable capacitor 50 may include a plurality of capacitors Cv1, Cv2, Cv3, Cv4, Cv5, Cv6, Cv7, Cv8, Cv9, and Cv10 connected to each other in parallel.

The variable capacitors 50 and 60 have a configuration for increasing a degree of precision of the oscillating frequency.

Therefore, the controlling unit 500 may generate the first control signal based on the oscillating output signal CLK_OUT.

For example, in the case in which the oscillating output signal CLK_OUT has a frequency different from a frequency having an expected output value, the controlling unit 500 may generate the first control signal for turning certain capacitors of the plurality of capacitors on and/or off.

According to the embodiment of the present invention, when one capacitor (for example, 100 fF) is turned on and/or off, a frequency of 0.1 Hz may be adjusted. In this case, as one arranged switch unit is turned on and/or off, the frequency may be adjusted in the 100 fF unit.

According to the configuration described above, the crystal oscillator capable of guaranteeing the degree of precision of the frequency may be provided.

The second control signal is a signal for adjusting a resistance value of the variable resistor 412.

FIG. 3 is a view illustrating an example of a variable resistor 412. For example, the variable resistor 412 may include a plurality of resistors Rdefault, Rv1, Rv1 x 2, Rv1 x 3, Rv1 x 4, and Rv1 x 5 connected to each other in parallel.

The variable resistor 412 has a configuration for adjusting the reference current of the reference current generating unit 410 so as to adjust a negative resistance of the driving unit 200. As the reference current of the reference current generating unit 410 is adjusted, the oscillating condition may be stably adjusted.

The controlling unit 500 may generate the second control signal based on the oscillating output signal CLK_OUT.

For example, in the case in which the oscillating output signal CLK_OUT is not stable, the controlling unit 500 may turn certain resistors of the plurality of resistors off. In this case, the current output from the reference current generating unit 410 may be increased and the current output from the current mirroring unit may also be increased. That is, as the current applied to the oscillating unit is increased, the oscillating output signal CLK_OUT may be stabilized.

Alternatively, although the oscillating output signal CLK_OUT is stable, the controlling unit 500 may turn certain resistors of the plurality of resistors on. In this case, the current output from the reference current generating unit 410 may be decreased and the current output from the current mirroring unit may also be decreased. That is, as the current applied to the oscillating unit is decreased, the power consumption of the crystal oscillator may be decreased.

According to the embodiment of the present invention, one resistor Rdefault may be set as a basic resistor. In addition, as one resistor other than the basic resistor is turned on and/or off, the current output from the reference current generating unit may be adjusted.

According to the configuration described above, the crystal oscillator capable of securing oscillating stability may be provided. In addition, the crystal oscillator capable of significantly increasing a life time of a battery may be provided.

The embodiments for detecting the load short described above may be used separately or in combination with each other. In addition, the operations configuring the respective embodiments may be used separately from or in combination with the operations configuring another embodiment.

In addition, the embodiments described above may be implemented in a recording medium that is readable by a computer or a device similar to the computer using, for example, software, hardware, or a combination thereof.

With hardware implementation, the embodiments described above may be implemented using at least one of application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors, and electrical units for performing other functions.

With software implementation, procedures and functions described in the specification may be implemented by separate software modules. The software modules may be implemented by a software code which is written by a suitable program language. The software code may be stored in a storage unit and may be executed by a processor.

As set forth above, according to the embodiment of the present invention, the crystal oscillator capable of significantly increasing the life time of the battery may be provided.

In addition, the crystal oscillator capable of securing oscillating stability may be provided.

In addition, a crystal oscillator capable of guaranteeing the degree of precision in a frequency may be provided.

While the present invention has been shown and described in connection with the embodiments, it will be apparent to those skilled in the art that modifications and variations can be made without departing from the spirit and scope of the invention as defined by the appended claims.

## Claims

1. A crystal oscillator, comprising:
an oscillating unit outputting an oscillating signal;
a driving unit driving the oscillating unit;
a waveform converting unit shaping a waveform of the oscillating signal;
a current supplying unit applying an operating signal to the driving unit and the waveform converting unit; and
a controlling unit applying a control signal to at least one of the oscillating unit and the current supplying unit, based on an output of the waveform converting unit.

2. The crystal oscillator of claim 1, wherein the oscillating unit includes a crystal vibrator, a load capacitor, and a feedback resistor.

3. The crystal oscillator of claim 1, wherein the oscillating unit includes a variable capacitor adjusting an oscillating frequency based on the control signal.

4. The crystal oscillator of claim 1, wherein the waveform converting unit includes a plurality of inverters.

5. The crystal oscillator of claim 1, wherein the current supplying unit includes a reference current generating unit and a current mirroring unit.

6. The crystal oscillator of claim 1, wherein the current supplying unit includes a variable resistor adjusting a reference current based on the control signal.

7. A crystal oscillator, comprising:
a waveform converting unit shaping and outputting an oscillating signal;
a controlling unit generating a control signal based on an output of the waveform converting unit; and
a current supplying unit outputting an operating signal based on the control signal of the controlling unit.

8. The crystal oscillator of claim 7, further comprising an oscillating unit outputting a predetermined oscillating signal based on the control signal of the controlling unit.
